# EUROPEAN PATENT SPECIFICATION

(11) **EP 2 203 931 B1**
(45) Date of publication and mention of the grant of the patent: **25.11.2015**
(21) Application number: 08845430.1
(22) Date of filing: 20.10.2008
(51) Int. Cl.: H01L 21/02, G06F 17/50, H01L 27/02, H01L 49/02

(54) **MULTILAYER CAPACTIVE STRUCTURE AND METHOD OF PRODUCING THE SAME**
MEHRSCHICHTIGE KONDENSATOR-STRUKTUR UND VERFAHREN ZU IHRER HERSTELLUNG
STRUCTURE CAPACITIVE MULTICOUCHE ET SON PROCÉDÉ DE PRODUCTION

(30) Priority: 02.11.2007 EP 07119859
(43) Date of publication of application: 07.07.2010
(73) Proprietor: IPDIA, 14000 Caen (FR)
(72) Inventor: TESSON, Olivier, (FR); LECORNEC, Francois, (FR)
(74) Representative: Cabinet Plasseraud
(86) International application number: PCT/IB2008/054302
(87) International publication number: WO 2009/057010

(56) References cited:
- US-A- 6 028 990
- US-B1- 6 229 163
- HIRAD SAMAVATI ET AL: "Fractal Capacitors" IEEE JOURNAL OF SOLID-STATE CIRCUITS, IEEE SERVICE CENTER, PISCATAWAY, NJ, US, vol. 33, no. 12, 1 December 1998 (1998-12-01), XP011060899 ISSN: 0018-9200
- MOSELHY T ET AL: "Investigation of space filling capacitors" PROCEEDINGS OF THE 15TH INTERNATIONAL CONFERENCE ON MICROELECTRONICS (IEEE CAT. NO.03EX686) ELECTRONICS AND COMMUNICATION DEPT., FACULTY OF ENG., CAIRO UNIV GIZA, EGYPT, 2003, pages 287-290, XP002520493 ISBN: 977-05-2010-1
- ROOZEBOOM F ET AL: "HIGH-DENSITY, LOW-LOSS MOS CAPACITORS FOR INTEGRATED RF DECOUPLING" PROCEEDINGS OF THE SPIE, SPIE, BELLINGHAM, VA; US, vol. 4587, 1 January 2001 (2001-01-01), pages 477-483, XP008076334 ISSN: 0277-786X

## Description

### FIELD OF THE INVENTION

The invention relates to a multilayer structure, in particular to a trench capacitor or three-dimensional capacitor.

The invention further relates to a method of producing a multilayer structure, in particular a trench capacitor.

### BACKGROUND OF THE INVENTION

High-density capacitors are essential to realize decoupling cells. To meet target impedance at a particular frequency, a capacitance value is chosen so that when placed in the layout design, it will resonate at the desired frequency, and have impedance that is equal to its Equivalent Series Resistance (ESR). Then a sufficient number of those capacitors are placed in parallel, so that the parallel ESR's approach the desired target impedance. Capacitor ESR determines the number of capacitors required to achieve certain target impedance at a particular frequency and is therefore an important design parameter. An over estimate of ESR leads to too many capacitors and unnecessary amount of materials, leading to unnecessary expenses. An underestimate of ESR can lead to inadequate power distribution system.

There are several ways to reach high-density capacitors by using the 3^{rd} dimension in the silicon. It is known in the art to produce trench capacitors utilizing anisotropic etching of a silicon substrate. In the conventional trench capacitor cell, the top electrode of the capacitor is formed inside the trench, and the bottom electrode is formed by the silicon substrate. Typically, the upper place or top electrode of the capacitor is a polysilicon layer extending into the trench, thereby forming a capacitor. However, the functionality of the capacitor relies on large surface areas. Trench capacitors are commonly built up into an array of a very large number of small deep holes or macro pores in the semiconductor substrate. However, the capacitor density is limited by the low diffusion rate through those deep holes, of the gaseous reagents used during plasma etching (DRIE) or further CVD deposition.

To overcome this issue, WO 2007/027169 proposes to use topological capacitor, wherein the drawing is reversed compared to the previous structure. In the article Fractal Capacitors (IEEE JOURNAL OF SOLID STATE CIRCUITS, VOL. 33, NO 12, Dec. 1998) by Hirad Samavati et al. linear capacitor structures using fractal geometries for the electrodes are described.

### OBJECT AND SUMMARY OF THE INVENTION

It may be an object of the present invention to provide an alternative multilayer structure, e.g. a trench capacitor, and a method of manufacturing an alternative multilayer structure, e.g. a trench capacitor, having a high density and a low Equivalent Series Resistance.

In order to achieve the object defined above, a multilayer structure, e.g. a trench capacitor, and a method of manufacturing the same according to the independent claims are provided. Advantageous embodiments are described in the dependent claims.

According to an exemplary embodiment a multilayer structure, in particular a trench capacitor or a battery, comprises a patterned layer structure comprising trenches, and a first electrode, wherein the patterned layer structure comprises a FASS-curve structure, and wherein at least parts of the first electrode are formed on the FASS-curve structure. In particular, it should be mentioned that the term "on the FASS-curve structure" may denote the fact that the first electrode is formed in the region of the FASS-curve structure, e.g. in, above or below the FASS-curve structure.

According to an exemplary embodiment a method of manufacturing a multilayer structure, in particular a trench capacitor or battery, comprises providing a substrate, e.g. a planar substrate, forming trenches in the substrate in such a way that a FASS structure is formed, e.g. by structuring the substrate, and forming an electrode at least on parts of the FASS structure. In particular, the trenches may be formed by etching, e.g. anisotropic etching and/or plasma etching. For the etching a mask may be used which may either have a shape of a FASS-curve or may have the shape of a complement of a FASS-curve. Optionally, an insulating layer may be deposited before the electrode is formed at least on parts of the FASS structure.

In this application the term "FASS-curve" may particularly denote a curve which is space-filling, self-avoiding, simple and self-similar. That is, a FASS-curve may be a curve which runs completely through a two-dimensional plane or three dimensional space (or a periodic grid specifying that plane/space). Such a FASS-curve may also be called a fractal curve. In particular, FASS-curves may be suited to be used in so-called design kits since a unit pattern, e.g. a smallest pattern unit, may be derivable from a FASS-curve. Thus, the using of a FASS-curve may not cause additional difficulties when implemented into a design kit.

In this application the term "multilayer structure" may particularly denote a three dimensional structure comprising a plurality, i.e. at least two layers. Such a multilayer structure may be used to form a battery, i.e. a micro-battery, or a trench capacitor. It should be noted that in principle the configuration or layout of a capacitor and a battery is rather similar. In particular, a capacitor may be formed by two electrodes which are insulated from each other, whereby one of these electrodes may be formed by ground potential, while a battery is formed by two electrodes, e.g. formed by polymer electrolyte material, which are in general not insulated from each other. Thus, for conciseness reasons, in the following only trench capacitors are mentioned although the further description and features apply for batteries, e.g. micro-batteries, as well. A trench capacitor may have one electrode arranged a least partially in trenches formed or etched into a substrate. The second electrode may be formed by the substrate itself or by an additional layer. In particular, according to this application a plate electrode of the trench capacitor may be formed either by the substrate or by the layer formed or deposited in the trenches. Consequently, also a storage electrode may be either formed by the substrate or by the layer formed in the trenches. In particular, a three-dimensional capacitor has to be distinguished from a quasi two dimensional capacitor. Such a quasi two-dimensional capacitor is characterized by a quasi two-dimensional structure in which the electrodes of the capacitor are formed side by side. In particular, no recesses or trenches are formed in a substrate which are then filled at least partially by a material to form an electrode. For example, two-dimensional capacitors may be formed by three layers deposited on each other, wherein the first layer forms a first electrode, the second layer forms a dielectric layer and the third layer forms the second electrode. Contrary to such a structure a three-dimensional capacitor may be characterized by a structure in which the top electrode comprises areas which are sunk in trenches which are formed in areas of the bottom electrode. Thus, a three-dimensional capacitor may comprise a top electrode having areas which are arranged below a top surface of a bottom electrode, e.g. side by side with regions of the bottom electrode, so that the top electrode may have a truly three-dimensional structure and is not only be formed by a planar layer. In particular, the first electrode and the second electrode may be interlocked with each other. Thus, a three-dimensional capacitor may comprise a top electrode formed partially on the bottom electrode, e.g. above the bottom electrode in a direction perpendicular to a main extension of the bottom electrode, and beside the bottom electrode.

The combination of a FASS-curve and a trench or three-dimensional capacitor may in particular lead to a decreased Equivalent Series Resistance (ESR). A reduction may be in the range of 50% compared to conventional topological capacitors as described in the above mentioned WO 2007/027169, for example. Furthermore, it may also be possible that such a structure may be efficiently formed, for example by an etching process having a high etching rate, which may also lead to a high level of integration. In particular, the structure achieved by using a FASS-curve may provide an open structure, leading to a high etching rate. Additionally, the reliability of the trench capacitor may be improved as the structure may prevent sticking which often occur when using conventional trench capacitors. Furthermore, the structure may be more robust than known topological capacitors since in principle only one trench and one single remaining region is formed. As the width of the trench shape may be constant all along the three-dimensional structure it may be possible that the materials used to fill the trenches may have a good homogeneity.

Moreover, the use of a substrate having a self-similar pattern may enabling a good predictability of the ESR and/or of the capacity of the three-dimensional capacitor, Thus, possibly leading to an improvement in the layout design.

A gist of an exemplary embodiment may be to use a FASS-curve, i.e. a self similar structure, for the patterning of a three-dimensional or trench capacitor, which may lead to a predictable capacity and/or ESR of the trench capacity, wherein the ESR may also decreased. A trench capacitor according to an exemplary embodiment may possible lead to a capacitor having minimized or reduced serial electrical resistance while maximizing or increasing capacitance value while possibly increasing the reliability during the manufacturing. Such reliability may in particular important for decoupling applications. According to exemplary embodiments of the invention, it may be possible to achieve very low levels of impedance at a certain frequency only by using optimized trench shapes within the capacitor.

Next, further exemplary embodiments of the trench capacitor are described. However, these embodiments also apply to the method of manufacturing a trench capacitor.

According to the present invention the trenches are formed by the FASS-curve structure. That is, the trenches may form a FASS-curve structure in the substrate. However, it may also be possible that the trenches form the complement to a FASS-curve, i.e. that the walls defining the trenches forming a FASS-curve. Thus, in case of forming the trenches by etching it may be possible to use an etching mask having the shape of a FASS-curve or to use a mask having a structure which is the complement of a FASS-curve.

According to another exemplary embodiment of the trench capacitor the layer structure comprises a substrate comprising a conductive material. In particular, a second electrode of the capacitor may be formed by the substrate of the patterned layer structure.

According to another exemplary embodiment of the trench capacitor the FASS-curve is a curve out of the group consisting of Hilbert curves, Peano-curves, Gosper curves, Sierpinski curves, E-curves, and Z-curves. All these curves may be suitable curves to efficiently run through a two dimensional plane or three-dimensional space, i.e. may be curves filling up and dividing a plane into self similar regions.

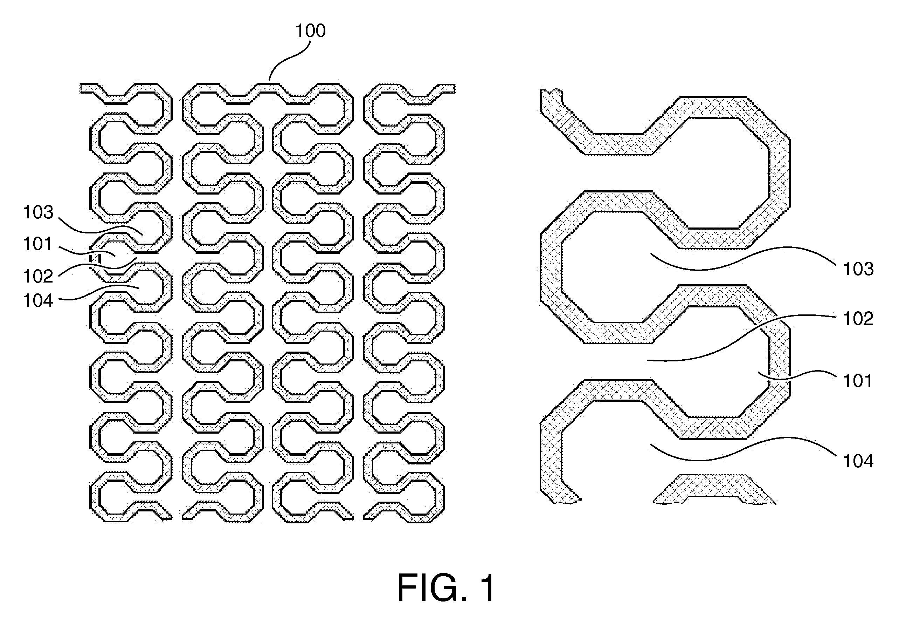

According to another exemplary embodiment of the trench capacitor the FASS-curve is a Peano-curve based on regular octagons. In particular, one side of each octagon is opened the respective octagon is connected to two adjacent octagons. In particular, the Peano-curve may be formed as shown in the following Fig. 1.

According to another exemplary embodiment of the trench capacitor the first electrode is formed by a continuous layer formed on the patterned substrate. That is, parts of the first electrode may be formed in the trenches and on top of the substrate leading to a single electrode on top of the whole substrate formed a single continuous layer.

The aspects and exemplary embodiments defined above and further aspects of the invention are apparent from the example of embodiment to be described hereinafter and are explained with reference to these examples of embodiment.

### BRIEF DESCRIPTION OF THE DRAWINGS

The invention will be described in more detail hereinafter with reference to examples of embodiment but to which the invention is not limited.
Fig. 1 schematically illustrates a pattern of a Peano-curve.
Fig. 2 schematically illustrates a perspective view of a substrate patterned by using the Peano-curve of Fig. 1.
Fig. 3 schematically illustrates a comparison of ESR and impedance of a known capacitor and a capacitor according to an exemplary embodiment of the invention.
Fig. 4 shows a microscopic image of a trench structure according to an exemplary embodiment of the invention.
Fig. 5 shows a microscopic image of a conventional trenched substrate.

### DESCRIPTION OF EMBODIMENTS

The illustration in the drawing is schematically. In different drawings, similar or identical elements are provided with similar or identical reference signs.

In the following an exemplary embodiment of a trench capacitor will described in more detail with reference to the Figs. 1 to 4.

**Fig. 1** schematically illustrates a pattern which can be used to manufacture a trench capacitor. Such a trench capacitor may also be called three-dimensional or topological capacitor. In principle, Fig. 1 shows a structure 100 based on a Peano-curve having a regular octagon 101 as a base unit. One side 102 of each octagon is opened so that adjacent octagons 103 and 104 can be connected to the respective octagon. In particular, the pattern shown in Fig. 1 may be used for a deep trench mask used to remove either the light parts in Fig. 1 or the shaded parts in Fig. 1.

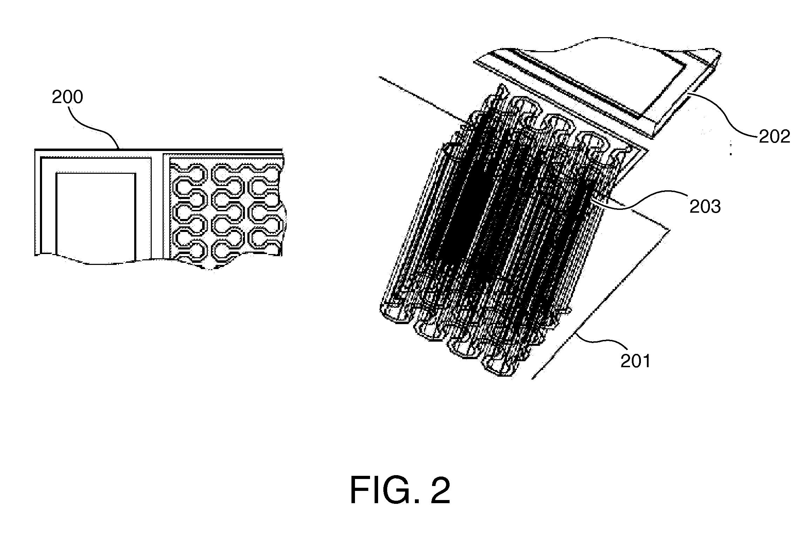

**Fig. 2** schematically illustrates a perspective view of a substrate patterned by using the Peano-curve of Fig. 1. In the left part of Fig. 2 a top view of a patterned substrate 200 is shown comprising a trench formed by the Peano-curve shown in Fig. 1. Furthermore, Fig. 2 shows the substrate 200 in a schematically perspective view on the right side. The substrate 200 is schematically indicated by a bottom layer 201 and a top layer 202 of the substrate, while the trench formed by the Peano-curve of Fig. 1 is indicated by the structure labeled 203 in Fig. 2.

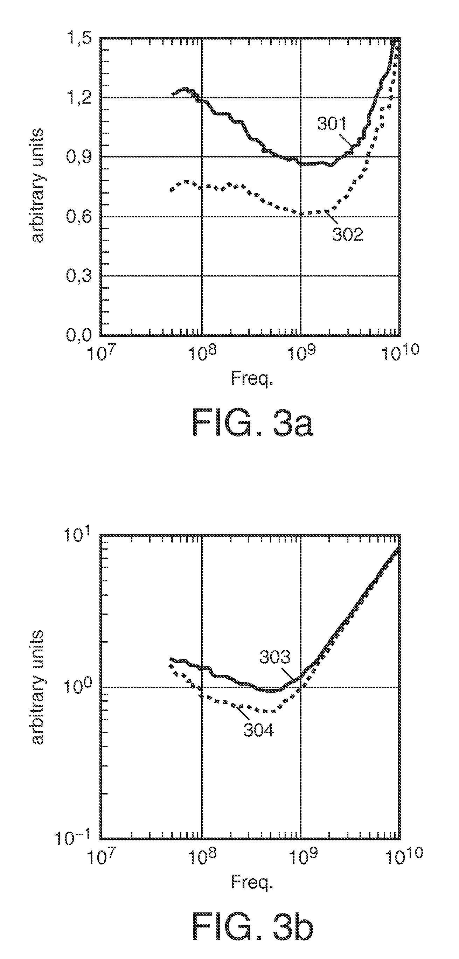

**Fig. 3** schematically illustrates a comparison of Equivalent Series Resistance (ESR) and impedance of a known capacitor and a capacitor according to an exemplary embodiment of the invention. In particular, Fig. 3a shows the development of ESR for a known capacitor 301 and for a three-dimensional capacitor 302 according to an exemplary embodiment of the invention for different frequencies. In particular, the ordinate shows arbitrary units representing the ESR while the abscissa shows a frequency range between 10 MHz and 10 GHz. As can be seen in Fig. 3a the ESR of the three-dimensional capacitor according to an exemplary embodiment of the invention is significantly smaller than that of the known topological capacitor. Fig. 3b shows the development of the impedance Z for a known capacitor 303 and for a three-dimensional capacitor 304 according to an exemplary embodiment of the invention for different frequencies. In particular, the ordinate shows arbitrary units representing the impedance while the abscissa shows a frequency range between 10 MHz and 10 GHz. As can be seen in Fig. 3b the impedance of the three-dimensional capacitor according to an exemplary embodiment of the invention is smaller than that of the known topological capacitor at least in the frequency range between about 50 MHz and about 2 GHz.

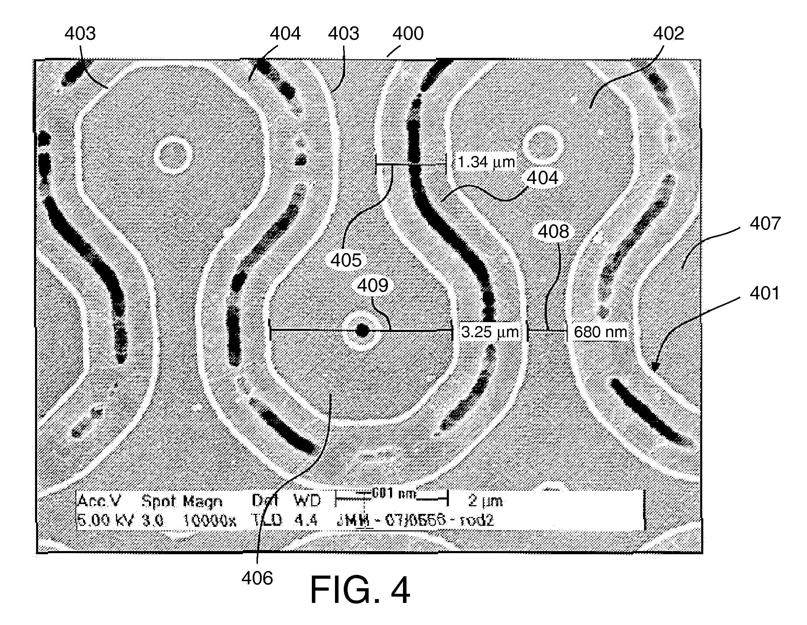

**Fig. 4** shows a microscopic cross-sectional view of a trench capacitor 400 according to an exemplary embodiment of the invention. The shown microscopic view is only for illustrative purpose in particular to show that it is possible to deposit an electrode rather homogeneous in a trench. In particular, Fig. 4 shows a trench 401 having a shape of a Peano-curve. In general the shape of the trench may also be called meander like. Furthermore, a first electrode or bottom electrode 402 is shown which is formed by a substrate of the capacitor. Moreover, the trench capacitor comprises an insulating layer 403, which is deposited into the trench 401 and has a thickness of approximately 19 nm, and a second electrode or top electrode 404 which is deposited onto the insulating layer 403 and into the regions of the trench which are not filled already by the insulating layer. Additionally, some exemplary dimensioning is shown in Fig. 4. As already mentioned the image, and thus the respective dimensions, are only for illustration purposes and not supposed to be limiting. The total width of the trench is indicated by the line 405 and is about 1.34 µm. A distance between a trench defining a first octagon 406 and a trench defining a second adjacent octagon 407 is indicated by line 408 and sums up to about 680 nm, while inside a single octagon the distance between two opposite sides is about 3.25 µm which is indicated by line 409. Furthermore, it can be seen in Fig. 4 that the deposition of the insulating layer 403 and the top electrode 404 may be performed rather homogenous which can be seen by the fact that the thickness of the insulating layer 403 is rather constant along the whole trench 401. Furthermore, the top electrode 404 is deposited rather homogenous on the insulating layer 403 which can be seen in the microscopic view of Fig. 4 as well.

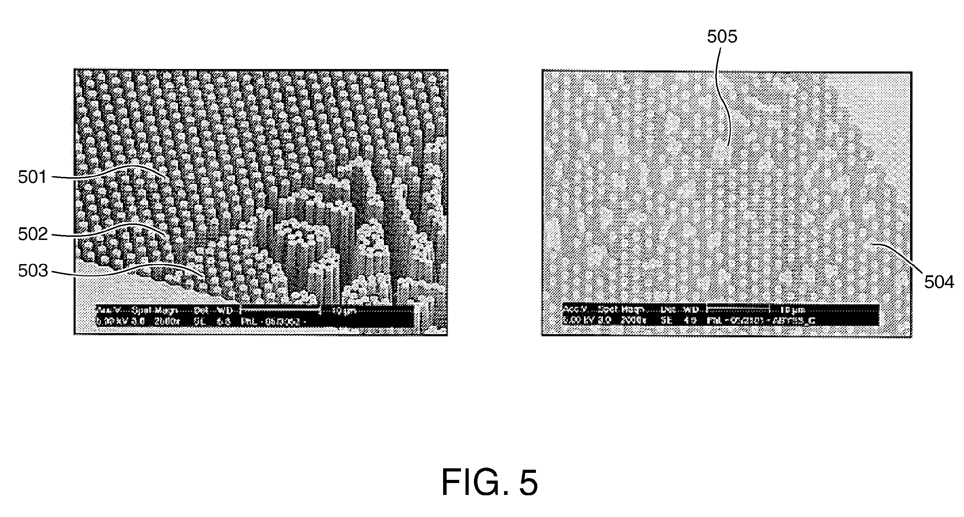

**Fig. 5** shows a perspective microscopic image and a top view microscopic image of a conventional trenched substrate similar to that disclosed in WO 2007/027169 having a great number of pins or studs 501, 502, 503 used for forming one of the electrodes. In particular, Fig. 5 shows a problem which might occur by such a structure, namely that some of the pins stick together as shown in particular in the right top view image at the areas labelled 504 and 505. This sticking may lead to the negative effect in the predictability of ESR and impedance.

Summarizing, according to an exemplary aspect of the invention a three-dimensional multilayer structure, e.g. a trench capacitor or a battery, may be provided having a high density of integration combined with a low ESR value while possibly showing a higher robustness than previously known topological capacitors. This may be achieved by providing a capacitor with a trench structure derived from a Peano-curve. Such, the pattern used to make the trench capacitor has the form of meanders. Thus, a robust and low-ohmic high-density 3D capacitor may be provided.

Finally, it should be noted that the above-mentioned embodiments illustrate rather then limit the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole.

## Claims

1. A trench capacitor (400), comprising:
a patterned substrate (402) comprising a trench, and
a top electrode (404),
**characterized in that** the patterned substrate comprises a FASS-curve structure (401) forming the trench,
**in that** a bottom electrode is formed by or in the FASS-curve structure,
**in that** an insulating layer is deposited into the trench, and
**in that** said top electrode (404) is deposited onto the insulating layer into regions of the trench which are not filled already by the insulating layer.

2. The trench capacitor (400) according to claim 1,
**characterized in that** the substrate (402) comprises a conductive material.

3. The trench capacitor (400) according to claim 1 or 2,
**characterized in that** the FASS-curve (401) is a curve from the group consisting of:
Hilbert curves,
Peano-curves,
Gosper curves,
Sierpinski curves,
E-curves, and
Z-curves.

4. The trench capacitor (400) according to claim 3,
wherein the FASS-curve (401) is a Peano-curve based on regular octagons.

5. The trench capacitor (400) according to claim 1,
wherein the top electrode (404) is formed by a continuous layer formed on the patterned substrate.

6. A method for manufacturing a trench capacitor (400) according to any of preceding claims,
**characterized in that** the method comprises following steps:
providing a substrate (402),
forming a trench (401) in the substrate (402) in such a way that a FASS structure is formed,
depositing an insulating layer in the trench and
depositing a top electrode (404) onto the insulating layer and into regions of the trench which are not filled already by the insulating layer.

## Patentansprüche

1. Grabenkondensator (400), umfassend:
ein gemustertes Substrat (402) mit einem Graben, und
eine Deckelelektrode (404),
**dadurch gekennzeichnet, dass** das gemusterte Substrat eine FASS-Kurven-Struktur (401) aufweist, die den Graben bildet,
dass eine Bodenelektrode durch oder in der FASS-Kurven-Struktur gebildet ist,
dass eine Isolierschicht im Graben abgelagert ist, und
dass die Deckelelektrode (404) auf der Isolierschicht in Bereichen des Grabens abgelagert ist, die nicht bereits mit der Isolierschicht gefüllt sind.

2. Grabenkondensator (400) nach Anspruch 1,
**dadurch gekennzeichnet, dass** das Substrat (402) ein leitendes Material umfasst.

3. Grabenkondensator (400) nach Anspruch 1 oder 2,
**dadurch gekennzeichnet, dass** die FASS-Kurve (401) eine Kurve aus der Gruppe ist, die aus Folgendem besteht:
Hilbert-Kurven,
Peano-Kurven,
Gosper-Kurven,
Sierpinski-Kurven,
E-Kurven und
Z-Kurven.

4. Grabenkondensator (400) nach Anspruch 3,
wobei die FASS-Kurve (401) eine Peano-Kurve auf Basis regelmäßiger Achtecke ist.

5. Grabenkondensator (400) nach Anspruch 1,
wobei die Deckelelektrode (404) durch eine kontinuierliche Schicht gebildet ist, die auf dem gemusterten Substrat gebildet ist.

6. Verfahren zur Herstellung eines Grabenkondensators (400) nach einem der vorhergehenden Ansprüche,
**dadurch gekennzeichnet, dass** das Verfahren die folgenden Schritte umfasst:
Bereitstellen eines Substrats (402),
Bilden eines Grabens (401) in dem Substrat (402), so dass eine FASS-Struktur gebildet wird,
Ablagern einer Isolierschicht in dem Graben, und
Ablagern einer Deckelelektrode (404) auf der Isolierschicht und in Bereichen des Grabens, die nicht bereits mit der Isolierschicht gefüllt sind.

## Revendications

1. Condensateur à tranchée (400), comprenant :
un substrat à motif (402) comprenant une tranchée, et
une électrode supérieure (404),
**caractérisé en ce que** le substrat à motif comprend une structure à courbe FASS (401) formant la tranchée,
**en ce qu'**une électrode inférieure est formée par ou dans la structure à courbe FASS,
**en ce qu'**une couche isolante est déposée dans la tranchée, et
**en ce que** ladite électrode supérieure (404) est déposée sur la couche isolante dans des régions de la tranchée qui ne sont pas déjà remplies par la couche isolante.

2. Condensateur à tranchée (400) selon la revendication 1,
**caractérisé en ce que** le substrat (402) comprend un matériau conducteur.

3. Condensateur à tranchée (400) selon la revendication 1 ou 2,
**caractérisé en ce que** la courbe FASS (401) est une courbe du groupe constitué par :
les courbes de Hilbert,
les courbes de Peano,
les courbes de Gosper,
les courbes de Sierpinski,
les courbes E, et
les courbes Z.

4. Condensateur à tranchée (400) selon la revendication 3,
dans lequel la courbe FASS (401) est une courbe de Peano basée sur des octogones réguliers.

5. Condensateur à tranchée (400) selon la revendication 1,
dans lequel l'électrode supérieure (404) est formée par une couche continue formée sur le substrat à motif.

6. Procédé de fabrication d'un condensateur à tranchée (400) selon l'une quelconque des revendications précédentes,
**caractérisé en ce que** le procédé comprend les étapes suivantes :
mise à disposition d'un substrat (402),
formation d'une tranchée (401) dans le substrat (402) d'une manière telle qu'une structure FASS est formée,
dépôt d'une couche isolante dans la tranchée, et
dépôt d'une électrode supérieure (404) sur la couche isolante et dans les régions de la tranchée qui ne sont pas déjà remplies par la couche isolante.
